# EUROPÄISCHE PATENTSCHRIFT

(11) **EP 2 987 392 B1**
(45) Veröffentlichungstag und Bekanntmachung des Hinweises auf die Patenterteilung: **29.03.2017**
(21) Anmeldenummer: 14718562.3
(22) Anmeldetag: 15.04.2014
(51) Int. Cl.: H05K 5/02

(54) **ELEKTRONISCHES GERÄT**
ELECTRONIC DEVICE
APPAREIL ÉLECTRONIQUE

(30) Priorität: 19.04.2013 AT 502672013
(43) Veröffentlichungstag der Anmeldung: 24.02.2016
(73) Patentinhaber: Siemens AG Österreich, 1210 Wien (AT)
(72) Erfinder: ASPERGER, Karl, A-1050 Wien (AT); SKUK, Oskar, A-1220 Wien (AT); JATSCHKA, Thomas, A-2102 Kleinengersdorf (AT)
(74) Vertreter: Maier, Daniel Oliver
(86) Internationale Anmeldenummer: PCT/EP2014/057639
(87) Internationale Veröffentlichungsnummer: WO 2014/170333

(56) Entgegenhaltungen:
- EP-A1- 0 540 376
- EP-A1- 2 466 682
- EP-A2- 2 330 528
- US-A1- 2002 014 962
- US-A1- 2005 088 303

## Beschreibung

Die Erfindung betrifft ein elektronisches Gerät mit besonderen Sicherheitsanforderungen, welches eine Leiterplatte umfasst, wobei die Leiterplatte umschlossen ist von einem Gehäuse, das zwei mittels einer Schraube verbundene Gehäuseteile umfasst, wobei eine Trennung der Gehäuseteile zwangsläufig eine Zustandsänderung des elektronischen Gerätes bewirkt, wobei ein erstes elektrisch leitendes Kontaktelement mit einem ersten Leiterplattenkontakt kontaktiert ist und an der Schraube im eingeschraubten Zustand anliegt und wobei ein zweites elektrisch leitendes Kontaktelement mit einem zweiten Leiterplattenkontakt kontaktiert ist und an der Schraube im eingeschraubten Zustand anliegt, sodass bei eingeschraubter Schraube zwischen den beiden Leiterplattenkontakten eine elektrische Verbindung besteht.

Elektronische Geräte unterliegen oftmals besonderen Sicherheitsanforderungen. Regelmäßig weisen sie geschlossene Gehäuse auf, welche den Zugriff auf elektronische Bauteile innerhalb des Geräts verhindern. Mehrteilige Gehäuse sind dabei zumeist verschraubt, um das Gehäuse bei Wartungs- oder Reparaturvorgängen öffnen zu können.

Oftmals wird mittels geeigneter Mittel verhindert, dass das Gehäuse durch einen Gerätenutzer geöffnet wird. Geschieht dies doch, bewirkt die Trennung der Gehäuseteile zwangsläufig eine Zustandsänderung des elektronischen Geräts. Beispielsweise ist auf einer Leiterplatte ein elektronischer Schalter angeordnet, welcher mit einem Gehäuseteil in Kontakt steht. Ein Lösen des Gehäuseteils betätigt den Schalter, wodurch das Gerät seinen Zustand ändert. Diese Änderung reicht zum Beispiel von einer elektronischen Protokollierung der Gerätemanipulation bis zu einer dauerhaften Funktionseinschränkung des Geräts.

Aus der US 2005/088303 A1 ist ein elektronisches Gerät mit zwei Gehäusehälften bekannt, welche eine Leiterplatte umschließen und mittels einer Schraube geschlossen gehalten werden. Jedes Kontaktelement ist jeweils mit meinem Leiterplattenkontakt verbunden und liegt am Schaft der Schraube an. Solange der Schaft den Abstand der beiden Kontaktelemente überbrückt, besteht eine elektrische Verbindung zwischen den beiden Leiterplattenkontakten. Bei Unterbrechung dieser Verbindung wird eine Manipulation des Gerätes erkannt.

Ein Manipulationsschutz mit mehreren kontaktierten Gehäuse-Verschlussschrauben ist aus der US 2002/014962 A1 bekannt. Dabei sind die Schrauben über Kontaktelemente elektrisch verbunden. Wird eine Schraube herausgeschraubt, löst sich die Verbindung, wodurch eine Manipulation angezeigt wird.

Eine manipulationssichere, mehrlagige Leiterplattenanordnung ist aus der EP 2 330 528 A2 bekannt. Eine erste Lage bildet eine Leiterplatte, deren Oberseite mit einem Kryptographie-Prozessor bestückt ist. Eine flächig auf die Leiterplatte aufgebrachte Abstandslage weist an der Position des Prozessors eine Ausnehmung auf. Abgedeckt ist die Abstandslage mittels einer weiteren Lage, sodass der Prozessor allseitig umschlossen ist.

Die EP 0 540 376 A1 zeigt eine Anordnung mit einer Leiterplatte, die mittels einer Schraube zwischen zwei Gehäuseteilen gehalten ist. Rund um eine Ausnehmung zur Schraubendurchführung weist die Leiterplatte zwei konzentrisch angeordnete Kontaktflächen auf, welche im montierten Zustand mittels einer Beilagscheibe elektrisch verbunden sind. Ein Entfernen der Schraube und in weiterer Folge der Beilagscheibe unterbricht die Verbindung, wodurch ein Manipulationsversuch der Anordnung detektiert wird.

Ein elektronisches Gerät mit besonderen Sicherheitsanforderungen ist beispielsweise als Bordinformationssystem ausgebildet, wie es die EP 2 466 682 A1 offenbart.

Der Erfindung liegt die Aufgabe zugrunde, für ein elektronisches Gerät der eingangs genannten Art eine Verbesserung gegenüber dem Stand der Technik anzugeben.

Erfindungsgemäß wird diese Aufgabe gelöst durch die Merkmale des Anspruchs 1. Verbesserungen sind in abhängigen Ansprüchen angeführt.

Dabei ist ein erstes elektrisch leitendes Kontaktelement mit einem ersten Leiterplattenkontakt kontaktiert und liegt an der Schraube im eingeschraubten Zustand an. Zudem ist ein zweites elektrisch leitendes Kontaktelement mit einem zweiten Leiterplattenkontakt kontaktiert und liegt an der Schraube im eingeschraubten Zustand an, sodass bei eingeschraubter Schraube zwischen den beiden Leiterplattenkontakten eine elektrische Verbindung besteht. Über die elektrisch leitende Schraube erfolgt somit eine bei geschlossenem Gehäuse sichere und dauerhafte elektrische Verbindung der beiden Leiterplattenkontakte. Sobald die Schraube herausgeschraubt wird, löst sich diese elektrische Verbindung zwangsläufig, wodurch eine Zustandsänderung des Geräts ausgelöst wird. Beispielsweise registriert eine elektronische Schaltung die Unterbrechung der beiden Leiterplattenkontakte. Ein eigener Schalter, welcher an einen Gehäuseteil gekoppelt ist, entfällt. Das Blockieren eines Schalters, beispielsweise durch Einspritzen eines Klebstoffs, ist somit ausgeschlossen. Insgesamt ermöglicht die Erfindung einen einfachen und fehlertoleranten Aufbau eines abgesicherten Gerätegehäuses.

Erfindungsgemäß liegen die Kontaktelemente in der Weise an der Schraube an, dass die elektrische Verbindung der beiden Leiterplattenkontakte nur bei vollständig eingeschraubter Schraube gegeben ist. Damit wird verhindert, dass ein nur geringfügiges Öffnen des Gerätegehäuses folgenfrei bleibt. Sobald die Gehäuseteile mittels der Schraube gelockert werden, löst sich zwangsläufig die elektrische Verbindung zwischen den Leiterplattenkontakten mit der vorgesehenen Folge einer Gerätezustandsänderung.

In einer Ausprägung der Erfindung umfasst das elektronische Gerät ein Speicherelement und einen Mikroprozessor, wobei das Speicherelement zumindest teilweise gelöscht wird, sobald die elektrische Verbindung zwischen den Leiterplattenkontakten unterbrochen wird. Eine solche Maßnahme ist insbesondere sinnvoll bei Geräten mit besonderen Sicherheitsanforderungen hinsichtlich Integrität und Authentizität. Sind auf dem Speicherelement beispielsweise vertrauliche Daten oder kryptographische Schlüssel abgespeichert, führt ein Öffnen des Gerätegehäuses zwangsläufig zum Löschen dieser Daten. Eine unerwünschte Gerätemanipulation durch einen Gerätenutzer wird auf diese Weise sicher verhindert.

Eine Weiterbildung sieht vor, dass das elektronische Gerät eine in einem Fahrzeug angeordnete On-Board-Unit ist. Solche Geräte werden beispielsweise zur Mauterfassung genutzt und müssen deshalb gegen unberechtigte Zugriffe abgesichert sein. Da Mauterfassungsgeräte in großen Stückzahlen gefertigt werden, ist hier der einfache erfindungsgemäße Aufbau der Gehäuseabsicherung besonders vorteilhaft, weil sehr viele Bauelemente zum Detektieren einer Gerätemanipulation (z.B. Schalter) eingespart werden.

Günstig ist es, wenn wenigstens ein Kontaktelement als Metallfeder ausgebildet ist. Dann liegt das Kontaktelement mit einer Federkraft an der Schraube an, wodurch eine dauerhafte, vibrationsresistente elektrische Verbindung gegeben ist.

Für eine einfache Fertigung ist vorteilhafterweise vorgesehen, dass wenigstens ein Gehäuseteil als Kunststoff-Spritzgusserzeugnis gefertigt ist und dass wenigstens eines der Kontaktelemente mitgespritzt ist.

In einer Weiterbildung weist jeder Gehäuseteil Fortsätze auf, welche als Halterungen für die Leiterplatte ausgebildet sind. Die Leiterplatte wird während des Zusammenbaus des Gehäuses mittels dieser Halterungen fixiert, sodass keine weitere Leiterplattenbefestigung erforderlich ist. Solche Fortsätze können beispielsweise Befestigungsdome rund um die für die Anbringung der Schraube vorgesehenen Befestigungslöcher sein.

Günstig ist es zudem, wenn das erste Kontaktelement zwischen Leiterplatte und erstem Gehäuseteil eingeklemmt ist. Dasselbe gilt für das zweite Kontaktelement, das günstigerweise zwischen Leiterplatte und zweitem Gehäuseteil eingeklemmt ist. Auf diese Weise erfolgt eine elektrische Verbindung zwischen den Kontaktelementen und den Leiterplattenkontakten im Zuge des Gehäusezusammenbaus.

Eine weitere günstige Ausprägung sieht vor, dass das erste Kontaktelement zwischen erstem Gehäuseteil und dem Kopf der Schraube eingeklemmt ist. Des Weiteren ist es von Vorteil, wenn das zweite Kontaktelement in ein Befestigungsloch des zweiten Gehäuseteils ragt, sodass das Ende des zweiten Kontaktelements bei eingeschraubter Schraube am Schaft der Schraube anliegt. Sobald die Schraube in das Befestigungsloch eingeschraubt ist und der Schraubenkopf am Gehäuse ansteht, entsteht die elektrische Verbindung zwischen den Leiterplattenkontakten. Umgekehrt löst sich diese elektrische Verbindung, sobald der Schraubenkopf nur geringfügig herausgedreht wird. Eine solche Ausprägung ist zudem unempfindlich gegen Gehäuseverwindungen, weil die elektrischen Kontakte direkt an der Schraubstelle angeordnet sind.

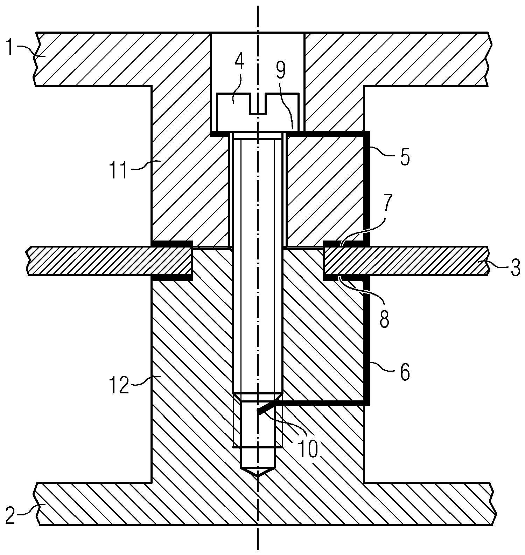

Die Erfindung wird nachfolgend in beispielhafter Weise unter Bezugnahme auf die beigefügte Figur erläutert.

In schematischer Darstellung zeigt die Fig. einen Ausschnitt eines zusammengebauten Gehäuses. Ein erster Gehäuseteil 1 ist mittels einer Schraube 4 mit einem zweiten Gehäuseteil 2 verbunden. Vorzugsweise sind die Gehäuseteile 1, 2 aus Kunststoff gespritzt. Sie sind dünnwandig ausgeführt, wobei rund um die Befestigungslöcher Befestigungsdome 11, 12 vorgesehen sind. Zudem weist das Befestigungsloch des ersten Gehäuseteils 1 eine zylindrische Senkung auf. In dieser Senkung ist der Kopf der Schraube 4 im montierten Zustand versenkt. Das Gewinde im Befestigungsloch des zweiten Gehäuseteils 2 entsteht günstigerweise infolge des Einsraubens der Schraube 4.

Die Befestigungsdome 11, 12 der beiden Gehäuseteile 1, 2 bilden eine Halterung für eine Leiterplatte 3. Beispielsweise ist der Befestigungsdom 12 des zweiten Gehäuseteils 2 an seinem Ende abgesetzt, wobei der Absatz mit einem Durchbruch der Leiterplatte 3 eine Spielpassung bildet. Fixiert wird die Leiterplatte 3 durch eine stirnseitige Auflage des Befestigungsdoms 11 des ersten Gehäuseteils 1. Eine zusätzliche Fixierung der Leiterplatte 3 ist nicht erforderlich.

Die Auflageflächen der Leiterplatte 3 auf den beiden Befestigungsdomen 11, 12 werden genutzt, um im montierten Zustand eine elektrische Verbindung zu zwei Kontaktelementen 5, 6 herzustellen. Die Leiterplatte 3 weist zu diesem Zweck rund um den Durchbruch auf jeder Seite einen Leiterplattenkontakt 7, 8 auf, der über Leiterbahnen mit einer elektronischen Schaltung verbunden sind. Kontaktiert ist jeder dieser Leiterplattenkontakte 7, 8 mit einem entsprechend geformten Kontaktelement 5, 6. Günstigerweise sind die Kontaktelemente 5, 6 aus Federstahl gefertigt und mit dem jeweiligen Gehäuseteil 1, 2 mitgespritzt. In einer alternativen Ausführung werden die Kontaktelemente 5, 6 nach dem Spritzgießen der Gehäuseteile 1, 2 in dafür vorgesehene Ausnehmungen eingelegt.

Das erste Kontaktelement 5 verbindet den ersten Leiterplattenkontakt 7 mit einer Schraubenkontaktfläche 9, welche beispielsweise in Form der ringförmigen Kopfstirnseite der Schraube am Übergang zum Schraubenschaft vorliegt. Dabei ist das Ende des Kontaktelements 5 gleichsam eine Beilagscheibe unterhalb des Schraubenkopfes, ohne dass die Innenkante dieser Scheibe den Schraubenschaft berührt. Somit besteht zwischen der Schraube 4 und dem ersten Kontaktelement 5 nur bei vollständig eingeschraubter Schraube 4 eine elektrische Verbindung.

Im zweiten Gehäuseteil 2 ist das Ende 10 des zweiten Kontaktelements 6 in der Weise in die Befestigungsbohrung geführt, dass die vollständig eingeschraubte Schraube 4 mit ihrem Schaft zwangsläufig gegen dieses Ende 10 des zweiten Kontaktelements 6 drückt. Somit besteht im montierten Zustand mittels des zweiten Kontaktelements 6 eine elektrische Verbindung zwischen der Schraube 4 und dem zweiten Leiterplattenkontakt 8. Die beiden Leiterplattenkontakte 7, 8 sind dann über die vollständig eingeschraubte Schraube 4 miteinander elektrisch verbunden.

Über Leiterbahnen sind die Leiterplattenkontakte 7, 8 mit einer nicht dargestellten elektronischen Schaltung verbunden. Diese umfasst beispielsweise ein Speicherelement und einen Mikroprozessor. Die elektronische Schaltung mit dem Mikroprozessor ist eingerichtet, um eine Unterbrechung der elektrischen Verbindung der beiden Leiterplattenkontakte 7, 8 zu erkennen und eine Zustandsänderung des elektronischen Geräts herbeizuführen.

In einem als On-Board-Unit zur Straßenmauterfassung ausgebildeten Gerät sind in dem Speicherelement vertrauliche Daten gespeichert. Diese müssen vor dem Zugriff des Gerätebenutzers geschützt sein. Sobald der Nutzer den Versuch unternimmt, das Gerät zu öffnen, indem er die Schraube 4 löst, unterbricht er zwangsläufig die elektrische Verbindung der beiden Leiterplattenkontakte 7, 8. Eine entsprechend eingerichtete elektronische Schaltung erkennt diese Unterbrechung und löscht die vertraulichen Daten in dem Speicherelement. Die On-Board-Unit ist daraufhin unbrauchbar und kann beispielsweise nur vom Hersteller oder Mautbetreiber in einen Ursprungszustand zurückgesetzt werden.

## Patentansprüche

1. Elektronisches Gerät mit besonderen Sicherheitsanforderungen, welches eine Leiterplatte (3) umfasst, wobei die Leiterplatte (3) umschlossen ist von einem Gehäuse, das zwei mittels einer Schraube (4) verbundene Gehäuseteile (1, 2) umfasst, wobei eine Trennung der Gehäuseteile (1, 2) zwangsläufig eine Zustandsänderung des elektronischen Gerätes bewirkt, wobei ein erstes elektrisch leitendes Kontaktelement (5) mit einem ersten Leiterplattenkontakt (7) kontaktiert ist und an der Schraube (4) im eingeschraubten Zustand anliegt und wobei ein zweites elektrisch leitendes Kontaktelement (6) mit einem zweiten Leiterplattenkontakt (8) kontaktiert ist und an der Schraube (4) im eingeschraubten Zustand anliegt, sodass bei eingeschraubter Schraube (4) zwischen den beiden Leiterplattenkontakten (7, 8) eine elektrische Verbindung besteht, **dadurch gekennzeichnet, dass** die Kontaktelemente (5, 6) in der Weise an der Schraube (4) anliegen, dass die elektrische Verbindung der beiden Leiterplattenkontakte (7, 8) nur bei vollständig eingeschraubter Schraube (4) gegeben ist.

2. Elektronisches Gerät nach Anspruch 1, **dadurch gekennzeichnet, dass** das elektronische Gerät ein Speicherelement und einen Mikroprozessor umfasst und dass das Speicherelement zumindest teilweise gelöscht wird, sobald die elektrische Verbindung zwischen den Leiterplattenkontakten (7, 8) unterbrochen wird.

3. Elektronisches Gerät nach einem der Ansprüche 1 oder 2, **dadurch gekennzeichnet, dass** das elektronische Gerät eine in einem Fahrzeug angeordnete On-Board-Unit ist.

4. Elektronisches Gerät nach einem der Ansprüche 1 bis 3, **dadurch gekennzeichnet, dass** wenigstens ein Kontaktelement (5, 6) als Metallfeder ausgebildet ist.

5. Elektronisches Gerät nach einem der Ansprüche 1 bis 4, **dadurch gekennzeichnet, dass** wenigstens ein Gehäuseteil (1, 2) als Kunststoff-Spritzgusserzeugnis gefertigt ist und dass wenigstens eines der Kontaktelemente (5, 6) mitgespritzt ist.

6. Elektronisches Gerät nach einem der Ansprüche 1 bis 5, **dadurch gekennzeichnet, dass** jeder Gehäuseteil (1, 2) Fortsätze aufweist, welche als Halterungen für die Leiterplatte (3) ausgebildet sind.

7. Elektronisches Gerät nach einem der Ansprüche 1 bis 6, **dadurch gekennzeichnet, dass** das erste Kontaktelement (5) zwischen Leiterplatte (3) und erstem Gehäuseteil (1) eingeklemmt ist.

8. Elektronisches Gerät nach einem der Ansprüche 1 bis 7, **dadurch gekennzeichnet, dass** das zweite Kontaktelement (6) zwischen Leiterplatte (3) und zweitem Gehäuseteil (2) eingeklemmt ist.

9. Elektronisches Gerät nach einem der Ansprüche 1 bis 8, **dadurch gekennzeichnet, dass** das erste Kontaktelement (5) zwischen erstem Gehäuseteil (1) und dem Kopf der Schraube (4) eingeklemmt ist.

10. Elektronisches Gerät nach einem der Ansprüche 1 bis 9, **dadurch gekennzeichnet, dass** das zweite Kontaktelement (6) in ein Befestigungsloch des zweiten Gehäuseteils (2) ragt, sodass es bei eingeschraubter Schraube (4) am Schaft der Schraube (4) anliegt.

## Claims

1. Electronic device having particular security requirements which comprises a printed circuit board (3), wherein the printed circuit board (3) is enclosed by a housing having two housing parts (1, 2) joined by means of screw (4), wherein a separation of the housing parts (1, 2) automatically causes a change in state of the electronic device, wherein a first electrically conductive contact element (5) contacts a first printed circuit board contact (7) and is seated against the screw (4) in the screwed-in state and wherein a second electrically conductive contact element (6) contacts a second printed circuit board contact (8) and is seated against the screw (4) in the screwed-in state, such that when the screw (4) is screwed in an electrical connection exists between the two printed circuit board contacts (7, 8), **characterised in that** the contact elements (5, 6) are seated against the screw (4) in such a way that the electrical connection of the two printed circuit board contacts (7, 8) is made only when the screw (4) is fully screwed in.

2. Electronic device according to claim 1, **characterised in that** the electronic device comprises a storage element and a microprocessor and that the storage element is at least partially erased as soon as the electrical connection between the printed circuit board contacts (7, 8) is interrupted.

3. Electronic device according to claim 1 or 2, **characterised in that** the electronic device is an on-board unit arranged in a vehicle.

4. Electronic device according to one of claims 1 to 3, **characterised in that** at least one contact element (5, 6) is designed as a metal spring.

5. Electronic device according to one of claims 1 to 4, **characterised in that** at least one housing part (1, 2) is manufactured as an injection-moulded plastic product and that at least one of the contact elements (5, 6) is included in the injection moulding.

6. Electronic device according to one of claims 1 to 5, **characterised in that** each housing part (1, 2) has extensions which are designed as holders for the printed circuit board (3).

7. Electronic device according to one of claims 1 to 6, **characterised in that** the first contact element (5) is sandwiched between the printed circuit board (3) and the first housing part (1).

8. Electronic device according to one of claims 1 to 7, **characterised in that** the second contact element (6) is sandwiched between the printed circuit board (3) and the second housing part (2).

9. Electronic device according to one of claims 1 to 8, **characterised in that** the first contact element (5) is sandwiched between the first housing part (1) and the head of the screw (4).

10. Electronic device according to one of claims 1 to 9, **characterised in that** the second contact element (6) projects into a mounting hole in the second housing part (2) such that it is seated against the shank of the screw (4) when the screw (4) has been screwed in.

## Revendications

1. Appareil électronique avec des exigences de sécurité particulières, lequel englobe un circuit imprimé (3), dans lequel le circuit imprimé (3) est entouré par une carcasse qui englobe deux parties de carcasse (1, 2) reliée au moyen d'une vis (4), une séparation des parties de carcasse (1, 2) induisant obligatoirement un changement d'état de l'appareil électronique, dans lequel un premier élément de contact électroconducteur (5) est en contact avec un premier contact de circuit imprimé (7) et est contigu à la vis (4) à l'état vissé et dans lequel un deuxième élément de contact électroconducteur (6) est en contact avec un deuxième contact de circuit imprimé (8) et est contigu à la vis (4) à l'état vissé, de sorte qu'une liaison électrique existe entre les deux contacts de circuit imprimé (7, 8) lorsque la vis (4) est vissée, **caractérisé en ce que** les éléments de contact (5, 6) sont contigus à la vis (4) de telle manière que la liaison électrique des deux contacts de circuit imprimé (7, 8) est uniquement donnée lorsque la vis (4) est intégralement vissée.

2. Appareil électronique selon la revendication 1, **caractérisé en ce que** l'appareil électronique englobe un élément de mémoire et un microprocesseur et **en ce que** l'élément de mémoire est au moins en partie supprimé dès que la liaison électrique entre les contacts de circuit imprimé (7, 8) est interrompue.

3. Appareil électronique selon l'une des revendications 1 ou 2, **caractérisé en ce que** l'appareil électronique est une unité embarquée dans un véhicule.

4. Appareil électronique selon l'une des revendications 1 à 3, **caractérisé en ce qu'**au moins un élément de contact (5, 6) est exécuté sous forme de ressort métallique.

5. Appareil électronique selon l'une des revendications 1 à 4, **caractérisé en ce qu'**au moins une partie de carcasse (1, 2) est fabriquée sous forme de produit en plastique moulé par injection et **en ce qu'**au moins un des éléments de contact (5, 6) est co-injecté.

6. Appareil électronique selon l'une des revendications 1 à 5, **caractérisé en ce que** chaque partie de carcasse (1, 2) présente des prolongements exécutés sous forme de supports pour le circuit imprimé (3).

7. Appareil électronique selon l'une des revendications 1 à 6, **caractérisé en ce que** le premier élément de contact (5) est inséré entre le circuit imprimé (3) et la première partie de carcasse (1).

8. Appareil électronique selon l'une des revendications 1 à 7, **caractérisé en ce que** le deuxième élément de contact (6) est inséré entre le circuit imprimé (3) et la deuxième partie de carcasse (2).

9. Appareil électronique selon l'une des revendications 1 à 8, **caractérisé en ce que** le premier élément de contact (5) est inséré entre la première partie de carcasse (1) et la tête de la vis (4).

10. Appareil électronique selon l'une des revendications 1 à 9, **caractérisé en ce que** le deuxième élément de contact (6) fait saillie dans un orifice de fixation de la deuxième partie de carcasse (2), de sorte à être contigu au corps de la vis (4) lorsque la vis (4) est vissée.
